# EUROPÄISCHE PATENTSCHRIFT

(11) **EP 0 764 982 B1**
(45) Veröffentlichungstag und Bekanntmachung des Hinweises auf die Patenterteilung: **12.12.2001**
(21) Anmeldenummer: 96114027.4
(22) Anmeldetag: 02.09.1996
(51) Int. Cl.: H01L 21/8238

(54) **Verfahren zur Herstellung einer integrierten CMOS-Schaltung**
Process for manufacturing an integrated CMOS circuit
Procédé pour la fabrication d'un circuit CMOS intégré

(30) Priorität: 25.09.1995 DE 19535629
(43) Veröffentlichungstag der Anmeldung: 26.03.1997
(73) Patentinhaber: Infineon Technologies AG, 81669 München (DE)
(72) Erfinder: Schwalke, Udo, Dr., 84431 Heldenstein (DE)
(74) Vertreter: Zedlitz, Peter, Dipl.-Inf.

(56) Entgegenhaltungen:
- EP-A- 0 660 394
- DE-A- 4 110 645
- US-A- 4 847 213
- US-A- 5 438 214
- US-E- R E34 158
- INTERNATIONAL JOURNAL OF HIGH SPEED ELECTRONICS AND SYSTEMS, Bd. 5, Nr. 2, 1994, Seiten 135-143, XP000195617 D. YU ET AL:

## Beschreibung

Verfahren zur Herstellung einer integrierten CMOS-Schaltung.

In CMOS-Logikschaltungen, zum Beispiel in Invertern werden sowohl n-Kanal-MOS-Transistoren als auch p-Kanal-MOS-Transistoren eingesetzt. Elektrische Verbindungen zwischen Gateelektroden von p-Kanal-MOS-Transistoren und n-Kanal-MOS-Transistoren werden dabei vielfach in einer Gateebene realisiert, die durch Strukturierung einer Schicht gebildet wird und die neben den Gateelektroden Verbindungselemente zwischen den Gateelektroden umfaßt. Vielfach sind die Gateelektroden und die Verbindungselemente zwischen den Gateelektroden als durchgehende Gateleitung realisiert. In CMOS-Schaltungen, die mit einer Versorgungsspannung von 5 Volt betrieben werden, wird die Gateebene meist aus n⁺-dotiertem Polysilizium oder Polyzid realisiert.

In CMOS-Schaltungen für Low-Voltage/Low-Power-Anwendungen, die mit einer Versorgungsspannung von < 3 Volt betrieben werden, werden die MOS-Transistoren so optimiert, daß sie Einsatzspannungen |Vₜₕ| < 0,4 Volt bei gleichzeitig niedrigen Leckströmen aufweisen. Die Gatelängen dieser MOS-Transistoren liegen unter 0,25 *µ*m. Die damit verbundenen hohen Anforderungen an das Kurzkanalverhalten der MOS-Transistoren werden durch Einsatz einer Dual-Workfunction-Gate-Technologie mit optimierter Gateaustrittsarbeit erfüllt. Unter Dual-Workfunction-Gate-Technologie wird die Tatsache verstanden, daß die Gateelektroden für die n-Kanal-MOS-Transistoren und die p-Kanal-MOS-Transistoren unterschiedlich dotiert sind. Wegen dieser unterschiedlichen Dotierung in den Gateelektroden besteht bei einer Gateebene mit durchgehender Gateleitung, die, unterschiedliche Gateelektroden verbindet, die Gefahr einer lateralen Dotierstoffdiffusion (siehe zum Beispiel L. C. Parillo, IEDM '85, p 398).

Die elektrischen Eigenschaften, zum Beispiel die Schwellenspannung Vₜₕ, der MOS-Transistoren hängt im wesentlichen von der Gatedotierung ab. Eine laterale Dotierstoffdiffusion führt zu einer Änderung der Gatedotierung und damit zu unerwünschten, nicht beherrschbaren Parameterverschiebungen. Im Extremfall kann es dabei zur Umdotierung von n⁺-dotierten bzw. p⁺-dotierten Gateelektroden und damit zum Totalausfall der Bauelemente kommen. Ferner müssen in der Verbindung zwischen n⁺-dotierten Gateelektroden und p⁺-dotierten Gateelektroden im Hinblick auf einen niedrigen Bahnwiderstand n⁺-dotierte Gebiete und p⁺-dotierte Gebiete unmittelbar aneinandergrenzen, da sich andernfalls eine Raumladungszone ausbildet.

Zur Unterdrückung der lateralen Dotierstoffdiffusion in der Dual-Workfunction-Gate-Technologie ist vorgeschlagen worden (siehe zum Beispiel D. C. H. Yu et al. Int. J. High Speed Electronics and Systems, Vol. 5, p 135, 1994), in der Gateebene keine durchgehenden Verbindung aus Polysilizium zwischen unterschiedlich dotierten Gateelektroden einzusetzen. Statt dessen wird die Gateleitung aus Polysilizium aufgetrennt und über eine Metallbrücke zum Beispiel aus Aluminium elektrisch leitend verbunden. Die Kontaktierung zwischen der Metallbrükke und den Gateleitungsstücken erfolgt über in einer dazwischen angeordneten Isolationsschicht geöffnete Kontaktlöcher. Alternativ wird nach dem Auftrennen der Gateleitung ein geeigneter metallischer Leiter, zum Beispiel TiN, W, WSi₂, abgeschieden und strukturiert. Diese Lösungen sind vom Prozeß her aufwendig und erfordern zum Teil zusätzlichen Platzbedarf für Kontaktierung und Metallisierung.

Ferner wurde vorgeschlagen (siehe C. Y. Wong et al, IEDM '88, p 238), die laterale Dotierstoffdiffusion in der Dual-Workfunction-Gate-Technologie durch eine Reduzierung der thermischen Belastung zu minimieren. Dieses führt jedoch zu einem engen Prozeßfenster, zum Beispiel bei der Dotierstoffaktivierung in der Gateelektrode und beim Planarisierungsreflow. Darüber hinaus hat dieser Lösungsvorschlag bisher nur zu unbefriedigenden Ergebnissen geführt.

US-A-4 847 213 offenbart ein herkömmliches Verfahren zur Herstellung integrierter CMOS-Schaltungen.

Der Erfindung liegt das Problem zugrunde, ein verbessertes Verfahren zur Herstellung einer integrierten CMOS-Schaltung anzugeben, bei dem die Gateelektroden der komplementären MOS-Transistoren unterschiedlich dotiert sind, bei dem die laterale Dotierstoffdiffusion unterdrückt wird und das mit gegenüber den bekannten Lösungen verringertem Prozeßaufwand durchführbar ist.

Dieses Problem wird erfindungsgemäß gelöst durch ein Verfahren nach Anspruch 1. Weitere Ausgestaltungen der Erfindung gehen aus den übrigen Ansprüchen hervor.

In dem erfindungsgemäßen Verfahren wird auf ein Substrat, das vorzugsweise eine monokristalline Siliziumscheibe ist, eine dielektrische Schicht und eine Siliziumschicht aufgebracht. Aus der dielektrischen Schicht wird im Laufe des Herstellverfahrens das Gatedielektrikum der MOS-Transistoren, aus der Siliziumschicht die Gateelektroden der MOS-Transistoren gebildet.

Im Bereich der Hauptfläche des Substrats werden Isolationsstrukturen erzeugt, die benachbarte Transistoren im Substrat isolieren. Bei der Bildung der Isolationsstrukturen wird die Siliziumschicht so strukturiert, daß die strukturierte Siliziumschicht mehrere Teilgebiete umfaßt. Diese Teilgebiete sind jeweils durch die Isolationsstrukturen voneinander getrennt. Die Strukturierung der Siliziumschicht kann sowohl durch lokales Entfernen von Teilen der Siliziumschicht, zum Beispiel durch Ätzen, erfolgen als auch durch lokales Umwandeln von Teilen der Siliziumschicht in ein anderes Material, insbesondere in SiO₂. Diese Strukturierung erfolgt bei der Bildung der Isolationsstruktur, das heißt es wird keine zusätzliche Maske zur Strukturierung der Siliziumschicht benötigt.

Die strukturierte Siliziumschicht wird in Gebieten für erste MOS-Transistoren mit einem Kanal von einem ersten Leitfähigkeitstyp anders dotiert als in Gebieten für zweite MOS-Transistoren mit einem Kanal von einem zweiten, dem ersten entgegengesetzten Leitfähigkeitstyp. Die Dotierung in den Gebieten für die ersten MOS-Transistoren unterscheidet sich von der Dotierung in Gebieten für die zweiten MOS-Transistoren durch den Leitfähigkeitstyp und/oder die Dotierstoffkonzentration.

Es wird eine elektrisch leitfähige Schicht abgeschieden, die gemeinsam mit der strukturierten Siliziumschicht strukturiert wird. Die Strukturierung erfolgt unter Verwendung einer gemeinsamen Maske. Dabei werden aus der strukturierten Siliziumschicht Gateelektroden für die ersten MOS-Transistoren und die zweiten MOS-Transistoren und aus der elektrisch leitfähigen Schicht eine Metallisierungsebene gebildet. Die Metallisierungsebene umfaßt Gateleitungen, die unterschiedlich dotierte Gateelektroden miteinander verbindet.

Da die unterschiedliche Dotierung für die verschiedenen Gateelektroden erst nach der Strukturierung der Siliziumschicht erzeugt wird, ist eine Veränderung der Dotierung der unterschiedlichen Gateelektroden durch laterale Diffusion in der Siliziumschicht nicht möglich. Da die Strukturierung der Siliziumschicht bei der Bildung der Isolationsstrukturen erfolgt und die Isolationsstrukturen jeweils ein Gebiet für einen Transistor umgeben, sind die Teilgebiete der strukturierten Siliziumschicht jeweils oberhalb eines Gebietes für einen Transistor angeordnet und von den entsprechenden Isolationsstrukturen umgeben. Auf diese Weise wird ohne zusätzliche Maske eine Auftrennung der Siliziumschicht bewirkt. Die Strukturierung der Gateelektroden erfolgt später gemeinsam mit der Strukturierung der elektrisch leitfähigen Schicht zur Bildung der Metallisierungsebene. Da die Siliziumschicht vor der Dotierung so strukturiert wurde, daß sie mehrere voneinander getrennte Teilgebiete umfaßt, verläuft die elektrisch leitfähige Schicht teilweise an der Oberfläche der Siliziumschicht und teilweise an der Oberfläche der Isolationsstrukturen. Über die elektrisch leitfähige Schicht ist damit eine Verbindung zwischen getrennten Teilgebieten der strukturierten Siliziumschicht realisierbar, ohne daß zusätzliche Prozeßschritte zur Kontaktierung zwischen der Gateelektrode und der Metallisierungsebene erforderlich wären.

Es liegt im Rahmen der Erfindung, in Gebieten, in denen die ersten MOS-Transistoren gebildet werden, die strukturierte Siliziumschicht zu dotieren, während die strukturierte Siliziumschicht in Gebieten, in denen die zweiten MOS-Transistoren gebildet werden, durch eine erste Maske abgedeckt ist. Anschließend wird die strukturierte Siliziumschicht in Gebieten für die zweiten MOS-Transistoren dotiert, während die strukturierte Siliziumschicht in Gebieten für die ersten MOS-Transistoren durch eine zweite Maske abgedeckt ist.

Es liegt im Rahmen der Erfindung, vor der Dotierung der strukturierten Siliziumschicht in Gebieten für die ersten MOS-Transistoren unter Verwendung der ersten Maske eine Implantation zur Bildung von vom zweiten Leitfähigkeitstyp dotierten Wannen und eine Kanalimplantation für die ersten MOS-Transistoren durchzuführen. Entsprechend wird vor der Dotierung der strukturierten Siliziumschicht in Gebieten für die zweiten MOS-Transistoren unter Verwendung der zweiten Maske eine Implantation zur Bildung von vom ersten Leitfähigkeitstyp dotierten Wannen und eine Kanalimplantation für die zweiten MOS-Transistoren durchgeführt. Diese Implantationen werden mit einer solchen Energie durchgeführt, daß die Dotierstoffe durch die strukturierte Siliziumschicht und die dielektrische Schicht hindurch in das Substrat geschossen werden. Zur Ausheilung von Implantationsschäden in der dielektrischen Schicht kann in den Prozeßablauf eine Hochtemperaturtemperung eingefügt werden, da es keine laterale Diffusion zwischen unterschiedlich dotierten Gateelektroden gibt.

Vorzugsweise wird vor der Abscheidung der elektrischen leitfähigen Schicht ein Temperschritt zur Aktivierung der Dotierstoffe durchgeführt. Gegebenenfalls erfolgt bei diesem Temperschritt auch die Ausheilung der Implantationsschäden in der dielektrischen Schicht. Die Aktivierung der Dotierstoffe vor der Abscheidung der elektrisch leitfähigen Schicht hat den Vorteil, daß als elektrisch leitfähige Schicht auch solche Materialien geeignet sind, über die eine geringfügige Diffusion von Dotierstoffen möglich ist.

Die Isolationsstrukturen können sowohl in einem LOCOS-Prozeß als auch in einem Shallow-Trench-Isolation-Prozeß gebildet werden. In einem LOCOS-Prozeß wird eine Deckschicht aus einem nicht oxidierbaren Material gebildet, die mit Hilfe einer die Anordnung der Isolationsstrukturen definierenden Isolationsmaske strukturiert wird. Anschließend werden die Isolationsstrukturen durch lokale, thermische Oxidation gebildet. Dabei wirkt die strukturierte Deckschicht als Oxidationsmaske. Bei der lokalen, thermischen Oxidation wird der von der strukturierten Deckschicht unbedeckte Teil der Siliziumschicht zur Bildung der Isolationsstrukturen durchoxidiert. Dadurch entstehen Teilgebiete der strukturierten Siliziumschicht, die jeweils durch die Isolationsstrukturen voneinander getrennt sind.

Der LOCOS-Prozeß kann auch so geführt werden, daß mit Hilfe der Isolationsmaske sowohl die Deckschicht als auch die Siliziumschicht geätzt werden. Die lokale thermische Oxidation zur Bildung der Isolationsstrukturen erfolgt dann an der Oberfläche des Substrats.

Alternativ werden die Isolationsstrukturen als mit isolierendem Material gefüllte Gräben gebildet. Dazu werden in einem Shallow-Trench-Isolation-Prozeß mit Hilfe einer Ätzmaske in das Substrat Gräben geätzt, die mit isolierendem Material aufgefüllt werden.

Für Anwendungen, bei denen nur reduzierte Anforderungen an die Isolationsstrukturen gestellt werden, zum Beispiel für Low Voltage/Low Power-Anwendungen, ist es ausreichend, wenn die mit isolierendem Material gefüllten Gräben nur bis auf die Oberfläche des Substrats reichen. Die Gräben werden in diesem Fall in einem modifizierten Shallow-Trench-Isolationsprozeß nur bis auf die Oberfläche des Substrats geätzt und mit isolierendem Material aufgefüllt.

Im folgenden wird die Erfindung anhand der Ausführungsbeispiele und der Figuren näher erläutert.
- Figur 1: zeigt ein Substrat mit einer dielektrischen Schicht, einer Siliziumschicht und einer Deckschicht.
- Figur 2: zeigt das Substrat nach der Strukturierung der Deckschicht.
- Figur 3: zeigt das Substrat nach Bildung von Isolationsstrukturen in einem Poly-Buffered-LOCOS-Prozeß, bei dem die Siliziumschicht strukturiert wird.
- Figur 4: zeigt eine Aufsicht auf die in Figur 3 dargestellte Struktur.
- Figur 5: zeigt einen Schnitt durch das Substrat bei der Dotierung der strukturierten Siliziumschicht in Gebieten für erste MOS-Transistoren.
- Figur 6: zeigt einen Schnitt durch das Substrat bei der Dotierung der Siliziumschicht in Gebieten für zweite MOS-Transistoren.
- Figur 7: zeigt einen Schnitt durch das Substrat nach Abscheidung einer elektrisch leitfähigen Schicht und Bildung einer Maske für die Gatestrukturierung.
- Figur 8: zeigt eine Aufsicht auf das Substrat nach Strukturierung der Gateebene.
- Figur 9: zeigt den in Figur 8 mit IX-IX bezeichneten Schnitt durch das Substrat nach der Bildung der Gateebene.
- Figur 10: zeigt den in Figur 9 dargestellten Schnitt nach Bildung von Spacern an den Flanken der Gateelektroden.
- Figur 11: zeigt den in Figur 10 gezeigten Schnitt durch das Substrat bei der Source/Drain-Implantation für die ersten MOS-Transistoren.
- Figur 12: zeigt den in Figur 11 dargestellten Schnitt durch das Substrat bei der Source/Drain-Implantation für die zweiten MOS-Transistoren.
- Figur 13: zeigt den in Figur 12 gezeigten Schnitt durch das Substrat nach einer Temperung zur Aktivierung der Dotierstoffe der Source/Drain-Gebiete.
- Figur 14: zeigt den in Figur 8 mit XIV-XIV bezeichneten Schnitt durch das Substrat.
- Figur 15: zeigt einen Schnitt durch ein Substrat mit einer dielektrischen Schicht, einer Siliziumschicht und einer Deckschicht.
- Figur 16: zeigt den Schnitt durch das Substrat nach Bildung einer Isolationsmaske.
- Figur 17: zeigt den Schnitt durch das Substrat nach einer Grabenätzung, bei der die Deckschicht, die Siliziumschicht und die dielektrische Schicht strukturiert werden und bei der im Substrat Gräben gebildet werden, die mit isolierendem Material aufgefüllt werden.
- Figur 18: zeigt den Schnitt durch das Substrat bei der Dotierung der strukturierten Siliziumschicht in Gebieten für erste MOS-Transistoren.
- Figur 19: zeigt den Schnitt durch das Substrat bei der Dotierung der strukturierten Siliziumschicht in Gebieten für zweite MOS-Transistoren.
- Figur 20: zeigt den Schnitt durch das Substrat nach Abscheidung einer elektrisch leitfähigen Schicht und Bildung einer Maske für die Gatestrukturierung.
- Figur 21: zeigt eine Aufsicht auf das Substrat nach der Gatestrukturierung.
- Figur 22: zeigt den in Figur 21 mit XXII-XXII bezeichneten Schnitt durch das Substrat nach der Gatestrukturierung.
- Figur 23: zeigt den in Figur 22 gezeigten Schnitt durch das Substrat nach der Bildung von Spacern an den Flanken der Gateelektroden.
- Figur 24: zeigt den in Figur 23 dargestellten Schnitt durch das Substrat bei der Source/Drain-Implantation für die ersten MOS-Transistoren.
- Figur 25: zeigt den in Figur 24 dargestellten Schnitt durch das Substrat bei der Source/Drain-Implantation für die zweiten MOS-Transistoren.
- Figur 26: zeigt den in Figur 25 dargestellten Schnitt durch das Substrat nach einem Temperschritt zur Aktivierung der Source/Drain-Gebiete.
- Figur 27: zeigt den in Figur 21 mit XXVII-XXVII bezeichneten Schnitt durch das Substrat.

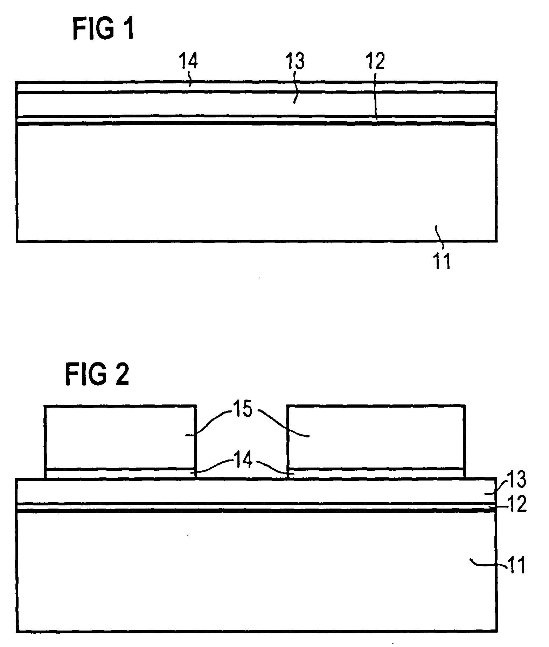

Auf ein Substrat 11 wird eine dielektrische Schicht 12, eine Siliziumschicht 13 und eine Deckschicht 14 aufgebracht (siehe Figur 1). Das Substrat 11 besteht zum Beispiel aus einer monokristallinen Siliziumscheibe. Die dielektrische Schicht 12 wird im weiteren Prozeßverlauf sowohl als Pad-Oxid für einen LOCOS-Prozeß als auch als Gatedielektrikum verwendet. Die dielektrische Schicht 12 wird zum Beispiel aus SiO₂ durch thermische Oxidation in einer Dicke von 3 bis 20 nm gebildet. Die Siliziumschicht, aus der im weiteren Verfahren Gateelektroden gebildet werden und die in einem Poly-Buffered-LOCOS-Prozeß als Buffer Layer verwendet wird, wird aus polykristallinem oder amorphem Silizium in einer Schichtdicke von 50 bis 200 nm abgeschieden. Die Deckschicht 4 wird aus nicht oxidierbarem Material, zum Beispiel aus Si₃N₄ gebildet. Die Deckschicht 14 wird zum Beispiel durch CVD-Abscheidung in einer Dicke von 20 bis 250 nm gebildet.

Mit Hilfe photolithographischer Prozeßschritte wird eine Isolationsmaske 15 aus Photolack gebildet (siehe Figur 2). Die Isolationsmaske definiert die Anordnung später herzustellender Isolationsstrukturen. In einem anisotropen Trockenätzprozeß, zum Beispiel mit CHF₃/O₂ wird die Deckschicht 14 entsprechend der Isolationsmaske 15 strukturiert (siehe Figur 2).

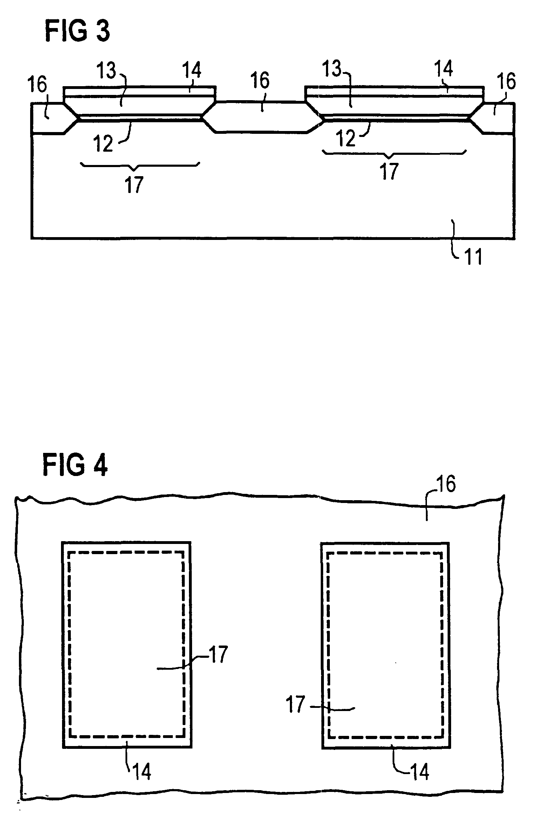

Nach Entfernen der Isolationsmaske 15 werden Isolationsstrukturen 16 in einem Poly-Buffered-LOCOS-Prozeß gebildet. Dabei wirken die dielektrische Schicht 12, die Siliziumschicht 13 und die Deckschicht 14 als LOCOS-Hardmaske. In dem Poly-Buffered-LOCOS-Prozeß wird die Siliziumschicht 13 dadurch strukturiert, daß von der Deckschicht 14 unbedeckte Teile der Siliziumschicht 13 aufoxidiert werden. Dadurch entsteht die strukturierte Siliziumschicht 13 mit Teilgebieten, die jeweils durch die Isolationsstrukturen 16 voneinander getrennt sind (siehe Figur 3). Die Isolationsstrukturen 16 umgeben aktive Gebiete 17 für MOS-Transistoren jeweils ringförmig (siehe Aufsicht in Figur 4). Die Teilgebiete der strukturierten Siliziumschicht 13 reichen jeweils über die aktiven Gebiete 17 hinaus bis auf die Isolationsstrukturen 16. Sie sind aber vollständig voneinander getrennt. In der Aufsicht in Figur 4 sind Größe und Lage der aktiven Gebiete 17 als gestrichelte Konturen eingezeichnet.

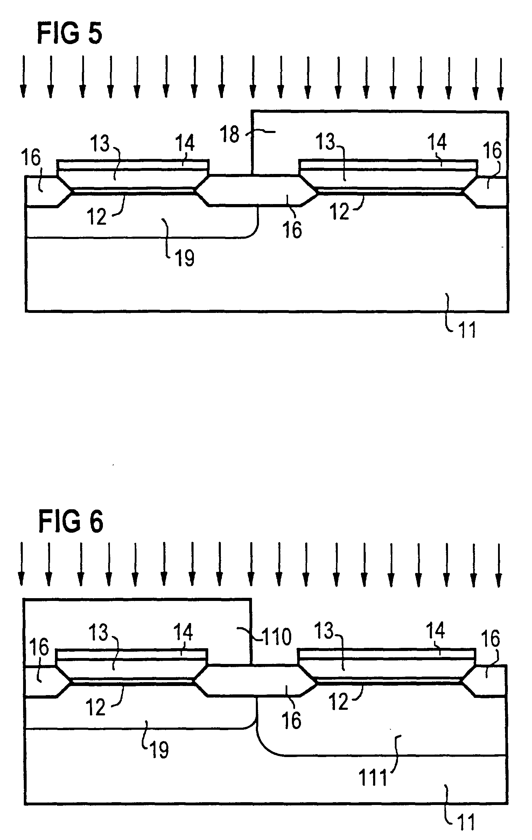

Es wird eine erste Maske 18 mit Hilfe photolithographischer Prozeßschritte aus Photolack erzeugt, die die aktiven Gebiete 17 für n-Kanal-MOS-Transistoren abdeckt (siehe Figur 5). Durch Implantation mit zum Beispiel Phosphor bei einer Energie von 500 keV und einer Dosis von 1 x 10¹³ at/cm² wird in den aktiven Gebieten 17 für die p-Kanal-MOS-Transistoren jeweils eine n-dotierte Wanne 19 gebildet.

Anschließend wird mit Phosphor bei einer Energie von 220 keV und einer Dosis von 3 x 10¹² at/cm² eine Kanalimplantation für die p-Kanal-MOS-Transistoren durchgeführt. Die Implantation der n-dotierten Wanne 19 und die Kanalimplantation werden mit so hoher Energie durchgeführt, daß die Dotierstoffe durch die Deckschicht 14, die Siliziumschicht 13, die dielektrische Schicht 12, die Kanalimplantation aber nicht notwendiger Weise durch die Isolationsstrukturen 16 hindurchgeschossen werden.

Anschließend wird eine p⁺-Implantation mit Bor mit einer Energie von zum Beispiel 20 keV und einer Dosis von zum Beispiel 3 x 10¹⁵ at/cm² durchgeführt. Dabei wird die Siliziumschicht 13 in den Gebieten für p-Kanal-MOS-Transistoren p⁺-dotiert. Die Energie wird bei dieser Implantation so eingestellt, daß die Dotierstoffe genau in die Siliziumschicht 13 geschossen werden.

Anschließend wird die erste Maske 18 entfernt. Mit Hilfe photolithographischer Prozeßschritte wird eine zweite Maske 110 erzeugt, die die aktiven Gebiete der p-Kanal-MOS-Transistoren abdeckt (siehe Figur 6). Durch Implantation mit Bor mit einer Energie von 250 keV und einer Dosis von 1 x 10¹³ at/cm² werden in aktiven Gebieten für n-Kanal-MOS-Transistoren p-dotierte Wannen 111 gebildet. Anschließend wird eine Kanalimplantation mit Bor bei einer Energie von 100 keV und einer Dosis von 3 x 10¹² at/cm² durchgeführt. Die Energie bei diesen Implantationen wird so gewählt, daß die Borionen durch die Deckschicht 14, die Siliziumschicht 13, die dielektrische Schicht 12, die Kanalimplantation aber nicht notwendiger Weise durch die Isolationsstrukturen 16 hindurch in das Substrat 11 geschossen werden. Durch Implantation mit Arsen bei einer Energie von 100 keV und einer Dosis von 5 x 10¹⁵ at/cm² wird die Siliziumschicht 13 im Bereich der n-Kanal-MOS-Transistoren n⁺-dotiert. Die Energie bei dieser Implantation wird so gewählt, daß die Ionen direkt in die Siliziumschicht 13 geschossen werden.

Nach Entfernen der zweiten Maske 110 wird ein Temperschritt zum Beispiel bei 900°C durchgeführt, wobei die implantierten Dotierstoffe aktiviert werden. Bei diesem Temperschritt werden gleichzeitig Defekte in der dielektrischen Schicht 12, die bei der Wannen- oder Kanalimplantation entstanden sind, ausgeheilt.

Anschließend wird die Deckschicht 14 entfernt. Es wird ganzflächig eine elektrisch leitfähige Schicht 112 abgeschieden. Aus der elektrisch leitfähigen Schicht 112 wird im folgenden Prozeßablauf eine Metallisierungsebene gebildet. Daher wird die elektrisch leitfähige Schicht vorzugsweise aus einem Material mit einem spezifischen Widerstand von höchstens 500 *µ*Ω . cm gebildet. Die elektrisch leitfähige Schicht 112 wird zum Beispiel aus Wolfram gebildet. Alternativ kann die elektrisch leitfähige Schicht 112 aus einem anderen Metall, Metallsilizid, TiN oder aus einer Schichtkombination aus Metall und Silizium, TiN und Silizium oder einem dünnen Dielektrikum (SiO₂, Si₃N₄) und dotiertem Silizium gebildet werden. Die elektrisch leitfähige Schicht 112 weist eine Dicke von zum Beispiel 200 nm auf.

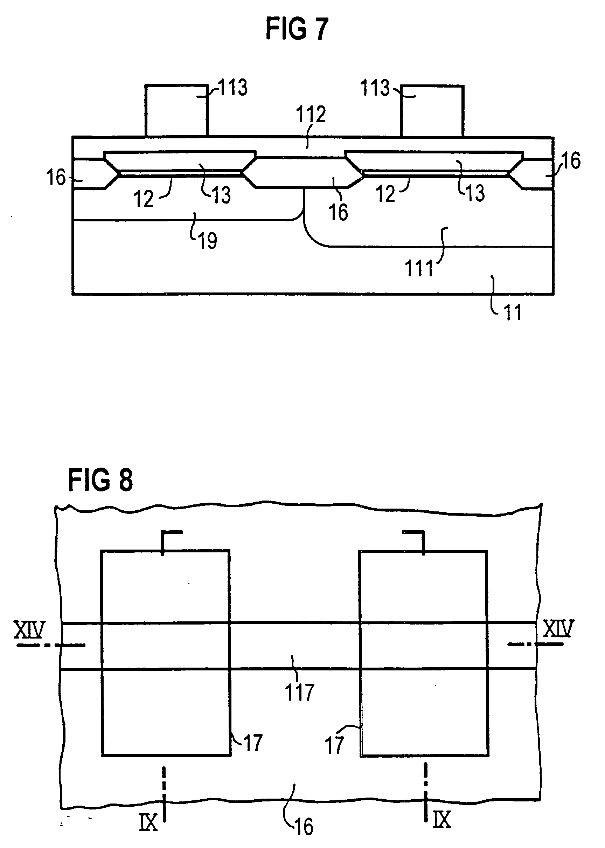

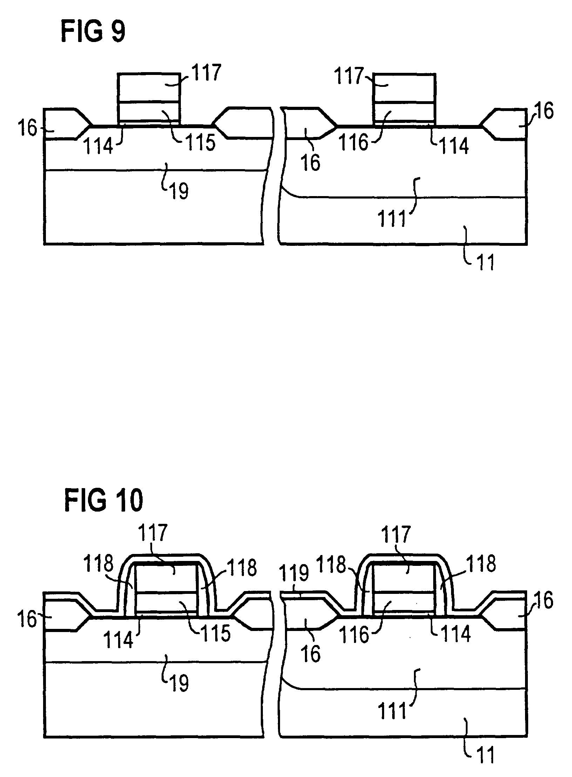

Auf der Oberfläche der elektrisch leitfähigen Schicht 112 wird mit Hilfe photolithographischer Prozeßschritte eine dritte Maske 113 aus Photolack erzeugt. Die dritte Maske 113 definiert Lage und Größe von Gateelektroden für die p-Kanal-MOS-Transistoren und die n-Kanal-MOS-Transistoren sowie für eine Metallisierungsebene (siehe Figur 7). Durch einen zweistufigen anisotropen Trockenätzprozeß zum Beispiel mit Cl₂ und HBr/Cl₂ werden die elektrisch leitfähige Schicht 112, die Siliziumschicht 13 und die dielektrische Schicht 12 strukturiert. Dabei wird aus der dielektrischen Schicht 12 ein Gatedielektrikum 114 gebildet. Aus der Siliziumschicht 13 werden p⁺-dotierte Gateelektroden für die p-Kanal-MOS-Transistoren und n⁺-dotierte Gateelektroden 116 für die n-Kanal-MOS-Transistoren gebildet. Aus der elektrisch leitfähigen Schicht 112 wird eine Metallisierungsebene 117 gebildet, die an der Oberfläche der Gateelektroden 115, 116 angeordnet ist und die Gateleitungen zwischen unterschiedlich dotierten Gateelektroden 115, 116 umfaßt (siehe Figur 8 und Figur 9). Die Metallisierungsebene 117 verläuft teilweise über die Isolationsstrukturen 16 und verbindet so unterschiedlich dotierte Gateelektroden 115, 116, die durch Strukturierung aus unterschiedlich dotierten Teilgebieten der strukturierten Siliziumschicht 13 entstanden sind. Die Metallisierungsebene 117 stellt dabei eine sehr gute elektrisch leitende Verbindung dar, die für eine laterale Dotierstoffdiffusion zwischen den unterschiedlich dotierten Gateelektroden 115, 116 undurchdringlich ist.

Seitlich der Gateelektroden 115, 116 liegt die Oberfläche des Substrats 11 in den aktiven Gebieten 17 frei. Durch konforme Abscheidung einer isolierenden Schicht und anisotropes Rückätzen der isolierenden Schicht werden an den Flanken der Gateelektroden 115, 116 und der Metallisierungsebene 117 isolierende Spacer 118 gebildet. Die isolierenden Spacer 118 werden zum Beispiel aus SiO₂, Si₃N₄, SiO₂ und Polysilizium oder Si₃N₄ und Polysilizium gebildet (siehe Figur 10). Es wird ganzflächig zum Beispiel durch CVD eine isolierende Schicht 119 aus zum Beispiel Si₃N₄ oder SiO₂ mit einer Schichtdicke von zum Beispiel 10 nm abgeschieden. Die isolierende Schicht 119 wirkt als Streuoxid für die nachfolgenden Implantationen und verhindert Dotierstoffausdiffusion bei Temperungen.

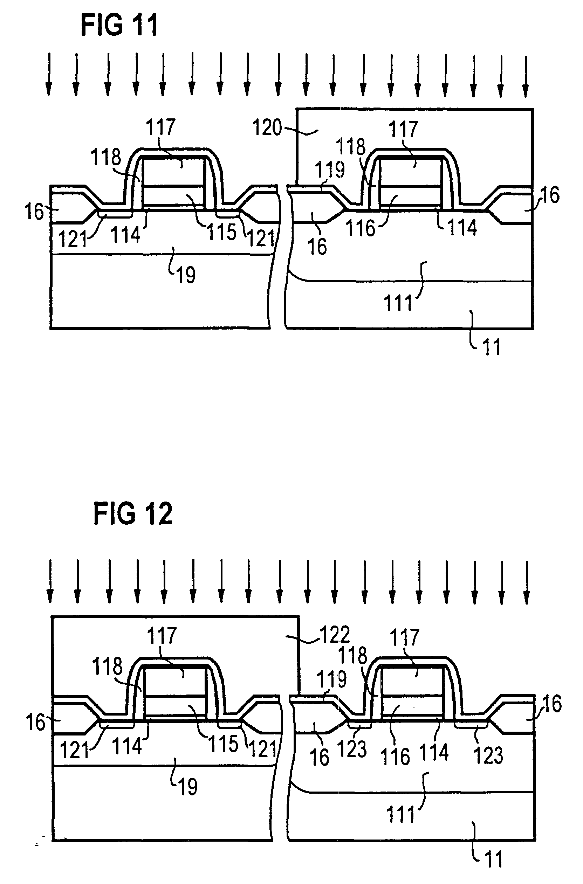

Mit Hilfe photolithographischer Prozeßschritte wird eine vierte Maske 120 gebildet aus Photolack, die die aktiven Gebiete für die n-Kanal-MOS-Transistoren abdeckt. Durch Implantation mit Bor mit einer Energie von 10 keV und einer Dosis von 4 x 10¹⁵ at/cm² werden p-dotierte implantierte Gebiete 121 selbstjustiert zu der p⁺-dotierten Gateelektrode 115 und den Isolationsstrukturen 116 gebildet (siehe Figur 11).

Nach Entfernen der vierten Maske 120 wird mit Hilfe photolithographischer Prozeßschritte eine fünfte Maske 122 aus Photolack gebildet, die die p-Kanal-MOS-Transistoren abdeckt. Durch Implantation mit Arsen mit einer Energie von 60 keV und einer Dosis von 4 x 10¹⁵ at/cm² werden n-dotierte implantierte Gebiete 123 gebildet. Die n-dotierten implantierten Gebiete 123 sind selbstjustiert zu den n⁺-dotierten Gateelektroden 116 und den Isolationsstrukturen 16 (siehe Figur 12). Die oberhalb der n⁺-dotierten Gateelektrode 116 angeordnete Metallisierungsebene 117 maskiert die n⁺-dotierte Gateelektrode 116 bei der Implantation.

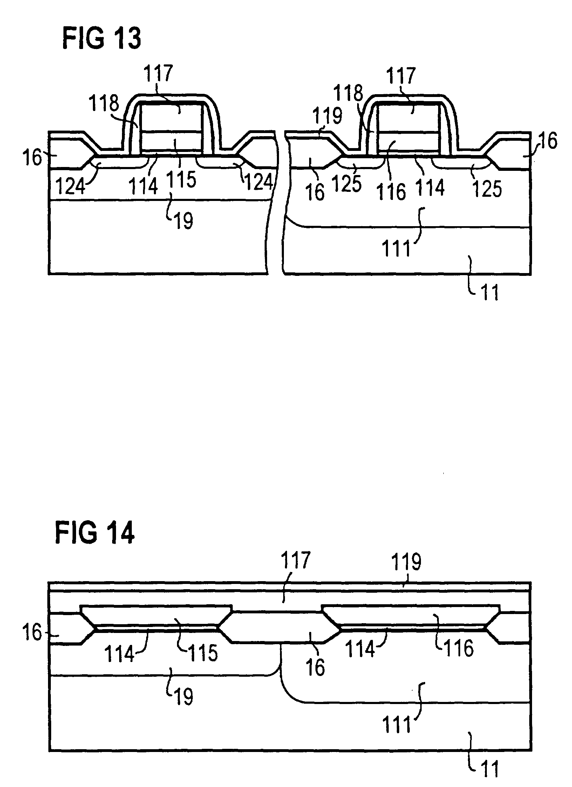

Nach Entfernen der fünften Maske 122 wird zur Aktivierung der Dotierstoffe ein Temperschritt bei zum Beispiel 900°C durchgeführt, bei dem sich aus den p-dotierten implantierten Gebieten 121 p-dotierte Source/Drain-Gebiete 124 und aus den n-dotierten implantierten Gebieten 123 n-dotierte Source/Drain-Gebiete 125 bilden (siehe Figur 13). In Figur 14 ist der in Figur 8 mit IV-IV bezeichnete Schnitt durch die Struktur dargestellt. Senkrecht zur Kanallänge sind die Gateelektroden 115, 116 zwischen gegenüberliegenden Isolationsstrukturen 16 ausgedehnt. Unterschiedlich dotierte Gateelektroden 115, 116 sind über die Metallisierungsebene 117 über die Isolationsstruktur 16 hinweg miteinander verbunden.

Die CMOS-Schaltung wird in bekannter Weise durch BPSG-Abscheidung, Planarisierung, Kontaktlochätzung und Metallisierung vervollständigt.

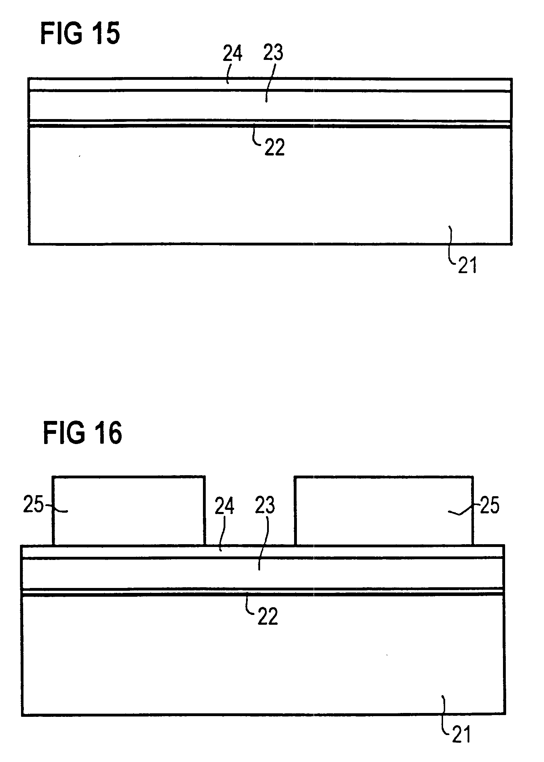

In einem weiteren Ausführungsbeispiel wird auf ein Substrat 21 aus monokristallinem Silizium eine dielektrische Schicht 22, eine Siliziumschicht 23 und eine Deckschicht 24 aufgebracht. Aus der dielektrischen Schicht 22 wird im weiteren Prozeßverlauf ein Gatedielektrikum gebildet. Die dielektrische Schicht 22 wird zum Beispiel durch thermische Oxidation aus SiO₂ in einer Schichtdicke von 3 bis 20 nm erzeugt. Die Siliziumschicht 23 wird aus polykristallinem oder amorphem Silizium in einer Dicke von 50 bis 400 nm abgeschieden. Die Deckschicht 24 wird zum Beispiel durch CVD-Abscheidung von Si₃N₄ in einer Schichtdicke von 50 bis 300 nm gebildet (siehe Figur 15).

Mit Hilfe photolithographischer Prozeßschritte wird eine Isolationsmaske 25 erzeugt, die die Anordnung von später herzustellenden Isolationsstrukturen definiert (siehe Figur 16).

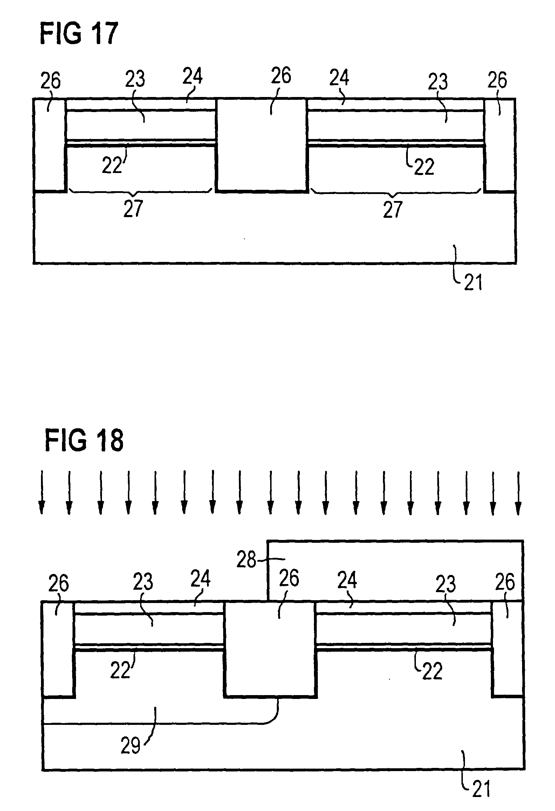

Mit Hilfe eines anisotropen mehrstufigen Trockenätzprozesses werden die Deckschicht 24, die Siliziumschicht 23 und die dielektrische Schicht 22 entsprechend der Isolationsmaske 25 strukturiert und Gräben in das Substrat 21 geätzt. Nach Entfernen der Isolationsmaske 25 werden die Gräben mit isolierendem Material, zum Beispiel SiO₂ gefüllt und mittels chemisch mechanischem Polieren planarisiert. Dabei werden Isolationsstrukturen 26, die aus den mit Oxid gefüllten Gräben bestehen, gebildet (siehe Figur 17). Die Isolationsstrukturen 26 werden nach dem sogenannten Shallow-Trench-Isolation-Prozeß gebildet. Da die dielektrische Schicht 22, aus der im weiteren Prozeßverlauf das Gatedielektrikum gebildet wird, vor der Grabenätzung abgeschieden wird und mit der Grabenätzung strukturiert wird, tritt in dem erfindungsgemäßen Verfahren das Problem der Oxiddünnungen, die sich im Shallow-Trench-Isolation-Prozeß am Rand der Gräben bei der Bildung des Gatedielektrikums bilden, nicht auf.

Die Isolationsstrukturen 26 umgeben aktive Gebiete 27 für p-Kanal-MOS-Transistoren und n-Kanal-MOS-Transistoren jeweils ringförmig. Ferner durchtrennen die Isolationsstrukturen 26 die Siliziumschicht 23 in Teilgebiete, die jeweils oberhalb eines aktiven Gebietes 27 angeordnet sind und die von Isolationsstrukturen 26 ringförmig umgeben sind.

Mit Hilfe photolithographischer Prozeßschritte wird eine erste Maske 28 aus Photolack erzeugt, die das aktive Gebiet für die n-Kanal-MOS-Transistoren abdeckt. Anschließend wird eine Ionenimplantation durchgeführt mit Phosphor bei einer Energie von 500 keV und einer Dosis von 1 x 10¹³ at/cm². Dabei wird für die p-Kanal-MOS-Transistoren eine n-dotierte Wanne 29 gebildet. Anschließend wird eine Kanalimplantation mit Phosphor bei einer Energie von 220 keV und einer Dosis von 3 x 10¹² at/cm² durchgeführt (siehe Figur 18). Die Energie bei diesen Implantationen wird so gewählt, daß die Ionen durch die Deckschicht 24 und die Siliziumschicht 23 und die dielektrische Schicht 22 hindurch in das Substrat 21 geschossen werden.

Durch Implantation mit Bor mit einer Energie von 20 keV und einer Dosis von 5 x 10¹⁵ at/cm² wird die Siliziumschicht 23 für p-Kanal-MOS-Transistoren p⁺-dotiert. Die Energie für diese Implantation wird so gewählt, daß die Dotierstoffe in die Siliziumschicht 23 geschossen werden.

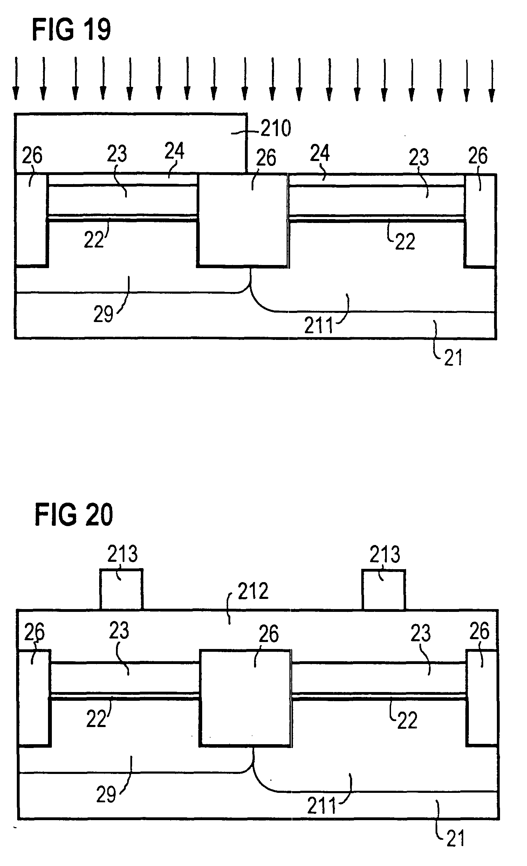

Nach Entfernen der ersten Maske 28 wird mit Hilfe photolithographischer Prozeßschritte eine zweite Maske 210 gebildet, die die Gebiete für p-Kanal-MOS-Transistoren abdeckt. Durch Implantation mit Bor mit einer Energie von 250 keV und einer Dosis von 1 x 10¹³ at/cm² wird eine p-dotierte Wanne 211 gebildet. Anschließend wird durch Implantation mit Bor mit einer Energie von 100 keV und einer Dosis von 3 x 10¹² at/cm² eine Kanalimplantation für die n-Kanal-MOS-Transistoren durchgeführt (siehe Figur 19). Die Energie bei diesen Implantationen wird so gewählt, daß die Dotierstoffe durch die Deckschicht 24, die Siliziumschicht 23, die dielektrische Schicht 22 hindurch in das Substrat geschossen werden. Anschließend wird eine Implantation mit Arsen bei einer Energie von 100 keV und einer Dosis von 5 x 10¹⁵ at/cm² durchgeführt, um die Siliziumschicht 23 in Gebieten für n-Kanal-MOS-Transistoren n⁺ zu dotieren. Die Energie bei dieser Implantation wird so eingestellt, daß die Dotierstoffe in die Siliziumschicht 23 hineingeschossen werden.

Nach Entfernen der zweiten Maske 210 wird ein Temperschritt zur Aktivierung der implantierten Dotierstoffe bei 900°C durchgeführt. Bei diesem Temperschritt werden auch Defekte in der dielektrischen Schicht 22, die bei der hochenergetischen Ionenimplantation zur Bildung der Wannen und der Kanalimplantationen entstanden sind, ausgeheilt.

Anschließend wird die Deckschicht 24 zum Beispiel naßchemisch entfernt.

Es wird ganzflächig eine elektrisch leitfähige Schicht 212 abgeschieden. Die elektrisch leitfähige Schicht 212 wird zum Beispiel aus Wolfram in einer Schichtdicke von zum Beispiel 200 nm gebildet. Die elektrisch leitfähige Schicht 212 kann auch aus einem anderen Metall, Metallsilizid, TiN oder einer Schichtkombination aus Metall und Silizium, Titannitrid und Silizium oder einem dünnen Dielektrikum und Silizium gebildet werden. Auf der Oberfläche der elektrisch leitfähigen Schicht 212 wird eine dritte Maske 213 gebildet, die Form und Anordnung von Gateelektroden, die durch Strukturierung aus der Siliziumschicht 23 gebildet werden, und einer Metallisierungsebene, die durch Strukturierung der elektrisch leitfähigen Schicht 212 gebildet wird, definieren (siehe Figur 20).

Die dritte Maske 213 wird mit Hilfe photolithographischer Prozeßschritte aus Photolack gebildet.

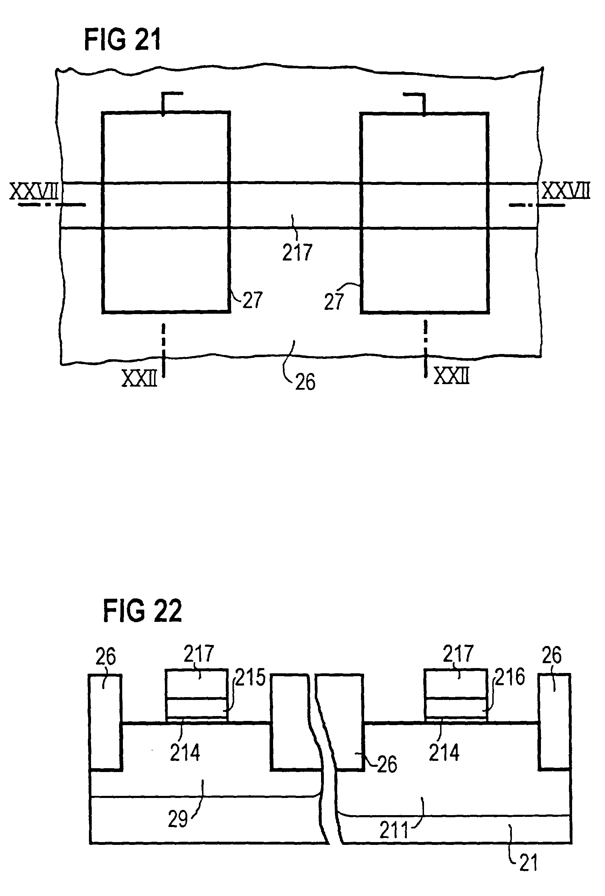

Durch anisotrope Trockenätzung werden die elektrisch leitfähige Schicht 212, die Siliziumschicht 23 und die dielektrische Schicht 22 strukturiert. Dabei entsteht aus der dielektrischen Schicht 22 ein Gatedielektrikum 214, aus der Siliziumschicht 23 in Gebieten für p-Kanal-MOS-Transistoren eine p⁺-dotierte Gateelektrode 215 und in Gebieten für n-Kanal-MOS-Transistoren eine n⁺-dotierte Gateelektrode 216 und aus der elektrisch leitfähigen Schicht 212 eine Metallisierungsebene 217 (siehe Figur 21 und Figur 22). Die Metallisierungsebene 217 bedeckt die Gateelektroden 215, 216 und verbindet unterschiedlich dotierte Gateelektroden 215, 216, die durch die Isolationsstrukturen 26 voneinander getrennt sind, elektrisch miteinander. Die Metallisierungsebene 217 erstreckt sich über die Gateelektroden 215, 216 hinaus und verläuft teilweise an der Oberfläche der Isolationsstrukturen 26. Über die Metallisierungsebene 217 wird eine elektrisch leitende Verbindung zwischen unterschiedlich dotierten Gateelektroden 215, 216 realisiert, ohne daß eine laterale Dotierstoffdiffusion zwischen den p⁺-dotierten Gateelektroden 215 und den n⁺-dotierten Gateelektroden 216 auftreten würde.

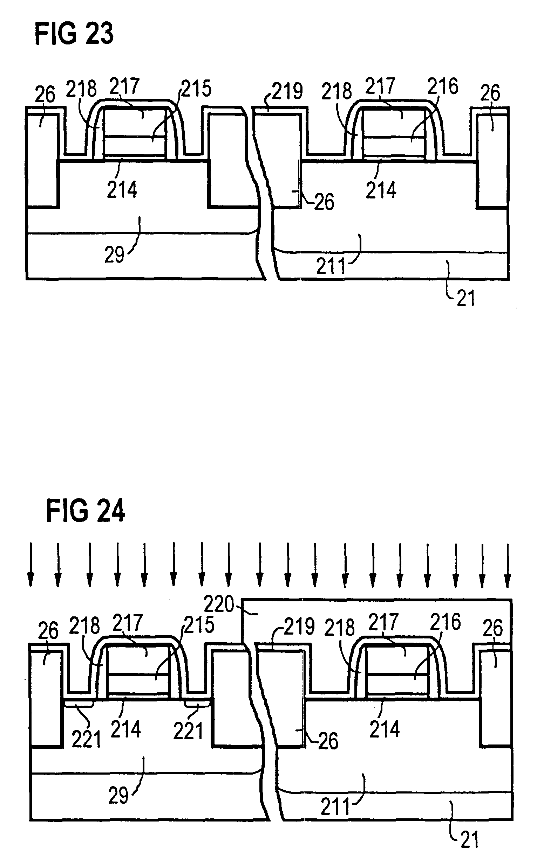

Zwischen den Isolationsstrukturen 26 und den Gateelektroden 215, 216 liegt die Oberfläche des Substrats 21 in den aktiven Gebieten 27 jeweils frei. Durch konforme Abscheidung einer isolierenden Schicht und anisotropes Rückätzen der isolierenden Schicht werden an den Flanken der Gateelektroden 215, 216 sowie der Metallisierungsebene 217 isolierende Spacer 218 gebildet. Die isolierenden Spacer 218 werden zum Beispiel aus SiO₂, Si₃N₄, SiO₂ und Polysilizium, Si₃N₄ und Polysilizium gebildet. Anschließend wird ganzflächig eine isolierende Schicht 219 aus Si₃N₄ oder SiO₂ abgeschieden. Die isolierende Schicht 219 wird in einer Schichtdicke von 10 bis 20 nm erzeugt und wirkt bei der nachfolgenden Source/Drain-Implantation als Streuoxid und bei einer nachfolgenden Planarisierung durch chemisch mechanisches Polieren als Ätzstop (siehe Figur 23).

Mit Hilfe photolithographischer Prozeßschritte wird eine vierte Maske 220 aus Photolack gebildet, die die Gebiete für n-Kanal-MOS-Transistoren abdeckt. Es wird eine Implantation mit Bor mit einer Energie von 10 keV und einer Dosis von 4 x 10¹⁵ at/cm² durchgeführt, bei der selbstjustiert zu den mit isolierenden Spacern 218 versehenen p⁺-dotierten Gateelektroden 215 und den umgebenden Isolationsstrukturen 26 p-dotierte implantierte Gebiete 221 gebildet werden (siehe Figur 24). Die Metallisierungsebene 217 deckt bei der Implantation die p⁺-dotierte Gateelektrode 215 ab.

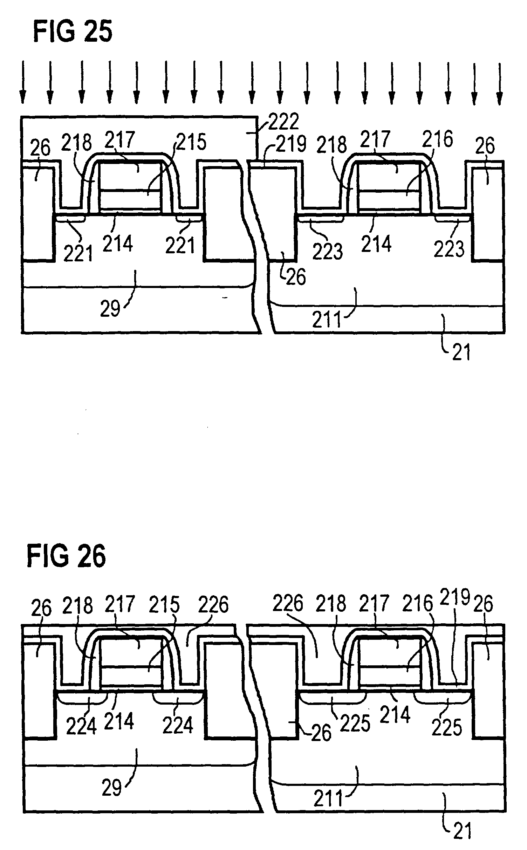

Nach Entfernen der vierten Maske 220 wird mit Hilfe photolithographischer Prozeßschritte eine fünfte Maske 222 aus Photolack gebildet (siehe Figur 25). Die fünfte Maske 222 deckt die Gebiete für p-Kanal-MOS-Transistoren ab. Es wird eine Implantation mit Arsen bei einer Energie von 60 keV und einer Dosis von 4 x 10¹⁵ at/cm² durchgeführt, bei der selbstjustiert zu den mit den isolierenden Spacern 218 versehenen n⁺-dotierten Gateelektroden 216 und den umgebenden Isolationsstrukturen 26 n-dotierte implantierte Gebiete 223 gebildet werden (siehe Figur 25). Bei der Implantation ist die n⁺-dotierte Gateelektrode 216 durch die Metallisierungsebene 217 abgedeckt.

Nach Entfernen der fünften Maske 222 wird ein Temperschritt zum Beispiel 900°C durchgeführt, um die implantierten Dotierstoffe zu aktivieren. Dabei bilden sich p⁺-dotierte Source/Drain-Gebiete 224 für die p-Kanal-MOS-Transistoren und n⁺-dotierte Source/Drain-Gebiete 225 für die n-Kanal-MOS-Transistoren.

Anschließend wird ein Zwischenoxid 226 abgeschieden und durch chemisch mechanisches Polieren planarisiert. Dabei wirkt die isolierende Schicht 219 oberhalb der Metallisierungsebene 217 als Ätzstopschicht (siehe Figur 26).

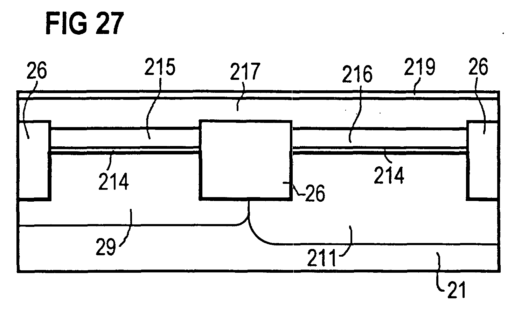

In Figur 27 ist der in Figur 21 mit XXVII-XXVII bezeichnete Schnitt dargestellt. Senkrecht zur Kanallänge erstrecken sich die Gateelektroden 215, 216 zwischen gegenüberliegenden Isolationsstrukturen 26. Die Gateelektroden 215, 216 von benachbarten MOS-Transistoren sind dabei durch die Isolationsstruktur 26 getrennt. Elektrisch sind Gateelektroden 215, 216 von benachbarten MOS-Transistoren über die Metallisierungsebene 217 verbunden. Eine laterale Dotierstoffdiffusion zwischen unterschiedlich dotierten Gateelektroden 215, 216 tritt nicht auf, da diese durch die Isolationsstrukturen 26 getrennt sind.

Die CMOS-Schaltung wird anschließend in üblicher Weise durch Kontaktlochätzung, Metallisierung, Passivierung etc. in bekannter Weise fertiggestellt (nicht dargestellt).

In diesem Ausführungsbeispiel kann vor der Abscheidung der isolierenden Schicht 219 (siehe Figur 23) auf der in den aktiven Gebieten 27 freiliegenden Oberfläche des Substrats 21 durch selektive Epitaxie Silizium aufgewachsen werden. Dadurch wird die Struktur planarisiert, so daß die Planarisierung des Zwischenoxids 226 vereinfacht wird. Ferner können durch diese Maßnahme in bezug auf die Lage des Gatedielektrikums 214 flachere Source/Drain-Gebiete 224, 225 realisiert werden. Die implantierten Gebiete 221, 223 werden in dem aufgewachsenen Silizium gebildet. Bei dem Temperschritt zum Aktivieren der Dotierstoffe entstehen die Source/Drain-Gebiete 224, 225 dann durch Ausdiffusion aus dem aufgewachsenen Silizium in dem Substrat 21.

Die dielektrische Schicht 12, 22 kann in beiden Ausführungsbeispielen alternativ aus nitridiertem Oxid gebildet werden. Nitridiertes Oxid wird durch Oxidation bei 1100°C, 5 bis 60 Sekunden in O₂-Atmosphäre, Nitridierung bei 900 bis 1100°C unter Verwendung von NH₃ und/oder N₂O und anschließende Reoxidation bei 1150°C gebildet. Nitridiertes Oxid wirkt als Dotierstoffbarriere. Dadurch wird sichergestellt, daß bei der Implantation der Siliziumschicht 13, 23 kein Dotierstoff in den Kanalbereich des später herzustellenden MOS-Transistors gelangt. Dieses Problem ist besonders bei der Dotierung mit Bor kritisch. In dem Fall, daß die Isolationsstrukturen durch einen LOCOS-Prozeß gebildet werden, wird die dielektrische Schicht aus nitridiertem Oxid in einer solchen Dicke hergestellt, daß die äquivalente Nitriddicke unter 4 nm liegt. Es wurde festgestellt, daß Nitrid in diesem Dickenbereich nicht als Oxidationsbarriere wirkt.

## Patentansprüche

1. Verfahren zur Herstellung einer integrierten CMOS-Schaltung,
- bei dem auf einem Substrat (11), das mindestens im Bereich einer Hauptfläche monokristallines Silizium umfaßt, eine dielektrische Schicht (12) und eine Siliziumschicht (13) abgeschieden werden,
- bei dem im Bereich der Hauptfläche des Substrats (11) Isolationsstrukturen (16) erzeugt werden, die benachbarte Transistoren im Substrat (11) isolieren werden,
- bei dem die Siliziumschicht (13) bei der Bildung der Isolationsstrukturen (16) so strukturiert wird, daß die strukturierte Siliziumschicht (13) mehrere Teilgebiete umfaßt, die jeweils durch die Isolationsstrukturen (16) voneinander getrennt sind,
- bei dem die strukturierte Siliziumschicht (13) in Gebieten für erste MOS-Transistoren mit einem Kanal von einem ersten Leitfähigkeitstyp anders dotiert wird als in Gebieten für zweite MOS-Transistoren mit einem Kanal von einem zweiten, dem ersten entgegengesetzten Leitfähigkeitstyp,
- bei dem eine elektrisch leitfähige Schicht (112) abgeschieden wird,
- bei dem die elektrisch leitfähige Schicht (112) und die strukturierte Siliziumschicht (13) gemeinsam strukturiert werden, wobei die Gateelektroden (115, 116) für die ersten und die zweiten MOS-Transistoren gebildet werden,
- bei dem Source-/Draingebiete (124, 125) für die ersten MOS-Transistoren und die zweiten MOS-Transistoren gebildet werden.

2. Verfahren nach Anspruch 1,
- bei dem die strukturierte Siliziumschicht (13) in Gebieten, in denen die ersten MOS-Transistoren gebildet werden, dotiert wird, während die strukturierte Siliziumschicht (13) in Gebieten, in denen die zweiten MOS-Transistoren gebildet werden, durch eine erste Maske (18) abgedeckt ist,
- bei dem die strukturierte Siliziumschicht (13) in Gebieten für die zweiten MOS-Transistoren dotiert wird, während die strukturierte Siliziumschicht (13) in Gebieten für die ersten MOS-Transistoren durch eine zweite Maske (110) abgedeckt ist.

3. Verfahren nach Anspruch 1 oder 2,
bei dem die strukturierte Siliziumschicht (13) in Gebieten für die ersten MOS-Transistoren vom ersten Leitfähigkeitstyp und in Gebieten für die zweiten MOS-Transistoren vom zweiten Leitfähigkeitstyp dotiert wird.

4. Verfahren nach einem der Ansprüche 1 bis 3,
- bei dem vor der Dotierung der strukturierten Siliziumschicht (13) in Gebieten für die ersten MOS-Transistoren unter Verwendung der ersten Maske (18) eine Implantation zur Bildung von vom zweiten Leitfähigkeitstyp dotierten Wannen (19) und eine Kanalimplantation für die ersten MOS-Transistoren erfolgt,
- bei dem vor der Dotierung der strukturierten Siliziumschicht (13) in Gebieten für die zweiten MOS-Transistoren unter Verwendung der zweiten Maske (110) eine Implantation zur Bildung von vom ersten Leitfähigkeitstyp dotierten Wannen (111) und eine Kanalimplantation für die zweiten MOS-Transistoren erfolgt.

5. Verfahren nach einem der Ansprüche 1 bis 4,
bei dem vor der Abscheidung der elektrisch leitfähigen Schicht (112) ein Temperschritt zur Aktivierung der Dotierstoffe durchgeführt wird.

6. Verfahren nach einem der Ansprüche 1 bis 5,
- bei dem auf die Siliziumschicht (13) eine Deckschicht (14) aufgebracht wird, die vor der Erzeugung der Isolationsstrukturen (16) mithilfe einer die Anordnung der Isolationsstrukturen (16) definierenden Isolationsmaske (15) strukturiert wird,
- bei dem die Deckschicht (14) vor der Abscheidung der elektrisch leitfähigen Schicht (112) entfernt wird.

7. Verfahren nach Anspruch 6,
- bei dem die Deckschicht (14) aus einem nicht oxidierbaren Material gebildet wird,
- bei dem die Isolationsstrukturen (16) durch eine lokale, thermische Oxidation gebildet werden, bei der die strukturierte Deckschicht (14) als Oxidationsmaske wirken.

8. Verfahren nach Anspruch 6,
bei dem zur Bildung der Isolationsstrukturen (16) unter Verwendung der strukturierten Deckschicht (14) als Ätzmaske in das Substrat (11) Gräben geätzt werden, die mit isolierendem Material aufgefüllt werden.

9. Verfahren nach einem der Ansprüche 1 bis 8,
- bei dem an den Flanken der Gateelektroden (115,116) der ersten und zweiten MOS-Transistoren isolierende Flankenbedekkungen (118) erzeugt werden,
- bei dem zur Bildung der Source-/Draingebiete (124) für die ersten MOS-Transistoren eine Ionenimplantation durchgeführt wird, bei der Gebiete für die zweiten MOS-Transistoren mit einer vierten Maske (120) abgedeckt sind,
- bei dem zur Bildung der Source-/Draingebiete (125) für die zweiten MOS-Transistoren eine Ionenimplantation durchgeführt wird, bei der Gebiete für die ersten MOS-Transistoren mit einer fünften Maske (122) abgedeckt sind.

10. Verfahren nach einem der Ansprüche 6 bis 9,
- bei dem die Siliziumschicht (13) aus polykristallinem Silizium gebildet wird,
- bei dem die leitfähige Schicht (112) ein hochschmelzendes Metall, ein Metallsilizid und/oder TiN enthält,
- bei dem die dielektrische Schicht (12) SiO₂ und/oder Si₃N₄ enthält,
- bei dem die Deckschicht (14) Si₃N₄ enthält,
- bei dem die Dotierung der strukturierten Siliziumschicht (13) durch Implantation erfolgt.

## Claims

1. Process for the production of an integrated CMOS circuit.
- in which a dielectric layer (12) and a silicon layer (13) are deposited on a substrate (11) which comprises monocrystalline silicon at at least one main face,
- in which insulation structures (16), which will insulate neighbouring transistors in the substrate (11), are produced at the main face of the substrate (11),
- in which the silicon layer (13) is structured during formation of the insulation structures (16) in such a way that the structured silicon layer (13) comprises a plurality of sub-regions which are each separated from one another by the insulation structures (16),
- in which, in regions for first MOS transistors with a channel of a first conductivity type, the structured silicon layer (13) is doped differently than in regions for second MOS transistors with a channel of a second conductivity type, opposite to the first,
- in which an electrically conductive layer (112) is deposited,
- in which the electrically conductive layer (112) and the structured silicon layer (13) are structured together, the gate electrodes (115, 116) for the first and second MOS transistors being formed,
- and in which the source/drain regions (124, 125) for the first MOS transistors and for the second MOS transistors are formed.

2. Process according to Claim 1,
- in which the structured silicon layer (13) is doped in regions in which the first MOS transistors are formed, while the structured silicon layer (13) is covered with a first mask (18) in regions in which the second MOS transistors are formed,
- and in which the structured silicon layer (13) is doped in regions for the second MOS transistors while the structured silicon layer (13) is covered with a second mask (110) in regions for the first MOS transistors.

3. Process according to Claim 1 or 2, in which the structured silicon layer (13) is doped in regions for the first MOS transistors with the first conductivity type, and in regions for the second MOS transistors with the second conductivity type.

4. Process according to one of Claims 1 to 3,
- in which implantation for forming wells (19) doped with the second conductivity type, and channel implantation for the first MOS transistors, take place before the structured silicon layer (13) is doped in regions for the first MOS transistors, by using the first mask (18),
- and in which implantation for forming wells (111) doped with the first conductivity type, and channel implantation for the second MOS transistors, take place before the structured silicon layer (13) is doped in regions for the second MOS transistors, by using the second mask (110).

5. Process according to one of Claims 1 to 4, in which a heat-treatment step for activating the dopants is carried out before the electrically conductive layer (112) is deposited.

6. Process according to one of Claims 1 to 5,
- in which a cover layer (14) is applied onto the silicon layer (13) and is structured before the insulation structures (16) are produced with the aid of an insulation mask (15) defining the arrangement of the insulation structures (16),
- and in which the cover layer (14) is removed before the electrically conductive layer (112) is deposited.

7. Process according to Claim 6,
- in which the cover layer (14) is formed by a non-oxidizable material,
- and in which the insulation structures (16) are formed by local thermal oxidation, in which the structured cover layer (14) acts as an oxidation mask.

8. Process according to Claim 6, in which trenches, which are filled with insulating material, are etched into the substrate (11) to form the insulation structures (16) by using the structured cover layer (14) as an etching mask.

9. Process according to one of Claims 1 to 8,
- in which insulating flank coverings (118) are produced on the flanks of the gate electrodes (115, 116) of the first and second MOS transistors,
- in which ion implantation is carried out to form the source/drain regions (124) for the first MOS transistors, during which the regions for the second MOS transistors are covered with a fourth mask (120),
- and in which ion implantation is carried out to form the source/drain regions (125) for the second MOS transistors, during which the regions for the first MOS transistors are covered with a fifth mask (122).

10. Process according to one of Claims 6 to 9,
- in which the silicon layer (13) is formed by polycrystalline silicon,
- in which the conductive layer (112) contains a high-melting metal, a metal silicide and/or TiN,
- in which the dielectric layer (12) contains SiO₂ and/or Si₃N₄,
- in which the cover layer (14) contains Si₃N₄,
- and in which the structured silicon layer (13) is doped by implantation.

## Revendications

1. Procédé de fabrication d'un circuit CMOS intégré,
- dans lequel on dépose sur un substrat (11), qui comprend au moins dans la zone d'une surface principale, du silicium monocristallin, une couche (12) diélectrique et une couche (13) en silicium,
- dans lequel on produit dans la zone de la surface principale du substrat (11) des structures (16) d'isolement, qui isolent des transistors voisins dans le substrat (11),
- dans lequel on structure la couche (13) en silicium lors de la formation des structures (16) d'isolement de telle manière que la couche (13) en silicium structuré comporte plusieurs sous-régions qui sont séparées les unes des autres chaque fois par les structures (16) d'isolement,
- dans lequel on dope la couche (13) en silicium structuré dans des régions pour des premiers transistors MOS ayant un canal d'un premier type de conductivité différemment que dans des régions pour des deuxièmes transistors MOS ayant un canal d'un deuxième type de conductivité, opposé au premier,
- dans lequel on dépose une couche (112) conductrice de l'électricité,
- dans lequel on structure conjointement la couche (112) conductrice de l'électricité et la couche (13) en silicium structuré, les électrodes (115, 116) de grille pour les premiers et les deuxièmes transistors MOS étant formés,
- dans lequel on forme des régions (124, 125) de source/drain pour les premiers transistors MOS et les deuxièmes transistors MOS.

2. Procédé suivant la revendication 1,
- dans lequel on dope la couche (13) en silicium structurée dans des régions dans lesquelles les premiers transistors MOS sont formés, tandis que l'on recouvre par un premier masque (18) la couche (13) en silicium structurée dans des régions dans lesquelles les deuxièmes transistors MOS sont formés,
- dans lequel on dope la couche (13) en silicium structurée dans des régions pour les deuxièmes transistors MOS, tandis que l'on recouvre par un deuxième masque (110) la couche (13) en silicium structurée dans des régions pour les premiers transistors MOS.

3. Procédé suivant la revendication 1 ou 2,
dans lequel on dope la couche (13) en silicium structurée dans des régions pour les premiers transistors MOS du premier type de conductivité et dans des régions pour les deuxièmes transistors MOS du deuxième type de conductivité.

4. Procédé suivant l'une des revendications 1 à 3,
- dans lequel on effectue avant le dopage de la couche (13) en silicium structurée dans des régions pour les premiers transistors MOS, en utilisant le premier masque (18), une implantation pour former des cuvettes (19) dopées du deuxième type de conductivité et une implantation de canal pour les premiers transistors MOS,
- dans lequel on effectue avant le dopage de la couche (13) en silicium structurée dans des régions pour les deuxièmes transistors MOS, en utilisant le deuxième masque (110), une implantation pour former des cuvettes (111) à dopage du premier type de conductivité et une implantation de canal pour les deuxièmes transistors MOS.

5. Procédé suivant l'une des revendications 1 à 4,
dans lequel on effectue avant le dépôt de la couche (112) conductrice de l'électricité une étape de recuit pour activer les substances dopantes.

6. Procédé suivant l'une des revendications 1 à 5,
- dans lequel on dépose sur la couche (13) en silicium une couche (14) de couverture que l'on structure avant la production des structures (16) d'isolement à l'aide d'un masque (15) d'isolement définissant la disposition des structures (16) d'isolement,
- dans lequel on enlève la couche (14) de couverture avant le dépôt de la couche (112) conductrice de l'électricité.

7. Procédé suivant la revendication 6,
- dans lequel on forme la couche (14) de couverture en un matériau non oxydable,
- dans lequel on forme les structures (16) d'isolement par une oxydation thermique locale lors de laquelle la couche (14) de couverture structurée sert de masque d'oxydation.

8. Procédé suivant la revendications 6,
dans lequel, pour former les structures (16) d'isolement, on ménage par attaque chimique, en utilisant la couche (14) de couverture structurée comme masque d'attaque chimique, des sillons dans le substrat (11) que l'on remplit de matériau isolant.

9. Procédé suivant l'une des revendications 1 à 8,
- dans lequel on produit sur les flancs des électrodes (115, 116) de grille des premier et deuxième transistors MOS des revêtements (118) de flancs d'isolement,
- dans lequel, pour former les régions (124) de source/drain pour les premiers transistors MOS, on effectue une implantation ionique lors de laquelle des régions pour les deuxièmes transistors MOS sont recouverts d'un quatrième masque (120),
- dans lequel, pour former les régions (125) de source/drain pour les deuxièmes transistors MOS, on effectue une implantation ionique lors de laquelle des régions pour les premiers transistors MOS sont recouverts d'un cinquième masque (122).

10. Procédé suivant l'une des revendications 6 à 9,
- dans lequel on forme la couche (13) en silicium polycristallin,
- dans lequel la couche (112) conductrice contient un métal à haut point de fusion, une siliciure de métal et/ou du TiN,
- dans lequel la couche (12) diélectrique contient du SiO₂ et/ou du Si₃N₄,
- dans lequel la couche (14) de couverture contient du Si₃N₄,
- dans lequel le dopage de la couche (13) en silicium structurée s'effectue par implantation.
